# EUROPEAN PATENT APPLICATION

(11) **EP 3 460 857 A1**
(43) Date of publication of application: **27.03.2019**
(21) Application number: 18769943.4
(22) Date of filing: 17.07.2018
(51) Int. Cl.: H01L 31/054

(54) **SOLAR POWER GENERATION ASSEMBLY**

(30) Priority: 17.07.2017 CN 201720867630 U
(71) Applicant: Beijing Juntai Innovation Technology Co., Ltd., Beijing 100176 (CN)
(72) Inventor: DUAN, Jun, Beijing 100176 (CN); HONG, Chengjian, Beijing 100176 (CN); HU, Dezheng, Beijing 100176 (CN); LI, Yuanmin, Beijing 100176 (CN); XU, Xixiang, Beijing 100176 (CN)
(74) Representative: Nordmeyer, Philipp Werner
(86) International application number: PCT/CN2018/095914
(87) International publication number: WO 2019/015564

(57) **Abstract**

A solar power generation component provided by the present disclosure includes a first substrate, a photoelectric transformation element, a reticular reflective layer and a second substrate deposed in sequence from top to bottom, the photoelectric transformation element includes a plurality of solar cell chips, the plurality of solar cell chips are disposed on the reticular reflective layer, and the adjacent solar cell chips define a gap, the reticular reflective layer includes a reticular frame located below the gaps among the plurality of solar cell chips.

## Description

### CROSS-REFERENCE TO RELATED APPLICATION

This application claims priority to Chinese Patent Application No 201720867630.8 filed on July 17, 2017, titled "SOLAR POWER GENERATION COMPONENT", which is incorporated herein by reference in its entirety.

### TECHNICAL FIELD

The present disclosure relates to a field of photovoltaic power generation technology, and in particular to a power generation component, and more particularly to a solar power generation component.

### BACKGROUND

Photovoltaic power generation is a recognized clean energy source. At present, various of photovoltaic manufacturers have concentrated their resources on developing double-sided power generation technology for use in high-efficiency batteries and photovoltaic components. Therefore, double-sided power generation technology has made great progress.

### SUMMARY

Some embodiments of the present disclosure provide a solar power generation component. The solar power generation component includes a first substrate, a photoelectric transformation element, a reticular reflective layer, and a second substrate arranged in sequence from top to bottom. The photoelectric transformation element includes a plurality of solar cell chips. The adjacent solar cell chips define a gap, the reticular reflective layer includes a reticular frame located below the gaps among the plurality of solar cell chips.

In some embodiments, the solar power generation component may further include a first adhesive layer and a second adhesive layer; wherein, the first substrate is adhesive with the plurality of solar cell chips by the first adhesive layer, and the reticular reflective layer is adhesive with the plurality of solar cell chips by the second adhesive layer.

In some embodiments, the reticular reflective layer may further include a plurality of through holes which are arranged as a reticular shape. A cross-sectional area of one of the plurality of through holes is greater than or equal to an area of a corresponding one of the plurality of solar cell chips, and an orthographic projection of the corresponding one of the plurality of solar cell chips on the second substrate is disposed within an orthographic projection of the one of the plurality of through holes on the second substrate, so that the reticular frame of the reticular reflective layer is located directly below the gaps which are provided among the plurality of solar cell chips.

In some embodiments, the reticular reflective layer may further include a plurality of grids each of which is composed by one of the plurality of through holes and corresponding edges of the reticular frame which surround the one of the plurality of through holes, one of the plurality of solar cell chips is disposed directly above a corresponding one of the plurality of grids.

In some embodiments, a width of one edge of the reticular frame may be less than or equal to a width of a corresponding gap which is provided among the plurality of solar cell chips.

In some embodiments, the solar power generation component further may include a third adhesive layer, wherein the reticular reflective layer is adhesive with the second substrate by the third adhesive layer.

In some embodiments, the first adhesive layer, the second adhesive layer or the third adhesive layer may be selected from any one of an ethylene-vinyl acetate copolymer adhesive layer, an ethylene-ethyl acrylate adhesive layer and a polyamide adhesive layer.

In some embodiments, the first substrate or the second substrate may be selected from any one of an ultra-clear tempered glass, an anti-reflection coated glass, an anti-reflective patterned glass and a transparent polymer backplane.

In some embodiments, the plurality of solar cell chips may be double-sided solar cell chips.

In some embodiments, a material of the reticular reflective layer may be a double-sided reflective material.

In some embodiments, a thickness of the reticular reflective layer may be 0.1 mm∼1 mm.

In some embodiments, an orthogonal projection of the reticular frame on the second substrate may be located within orthographic projections of the gaps on the second substrate.

In some embodiments, each of the plurality of through holes may include a first opening and a second opening oppositely arranged. The first opening is adjacent to the gaps, and the second opening is adjacent to the second substrate; an orthogonal projection of the first opening on the second substrate is greater than an orthogonal projection of the second opening on the second substrate; and the orthographic projection of the corresponding one of the plurality of solar cell chips on the second substrate is disposed within the orthographic projection of the second opening of the one of the plurality of through holes on the second substrate.

In some embodiments, a cross-section of at least one of the plurality of through holes in a plane perpendicular to the second substrate may be trapezoidal.

In some embodiments, an inner wall of each of the plurality of through holes may be provided with a directional reflection structure, and the directional reflection structure is configured to adjust a reflection angle of light emitted toward the inner wall of each of the plurality of through holes.

In some embodiments, the solar power generation component further includes a first adhesive layer and a third adhesive layer. The first substrate is adhesive with the plurality of solar cell chips by the first adhesive layer, and the reticular reflective layer is adhesive with the second substrate by the third adhesive layer. The reticular reflective layer is a double-sided reflective layer, and the plurality of solar cell chips are double-sided solar cell chips. A refractive index of the first adhesive layer is greater than that of the first substrate, a refractive index of the first substrate is greater than that of the air; a refractive index of the third adhesive layer is greater than that of the second substrate, and a refractive index of the second substrate is greater than that of the air.

In some embodiments, a surface of the reticular reflective layer close to the first substrate has a refractive index greater than 80%, and another surface of the reticular reflective layer close to the second substrate has a refractive index greater than 60%.

### BRIEF DESCRIPTION OF THE DRAWINGS

The accompanying drawings are used to provide a further understanding of the technical solutions of the present disclosure and constitute a part of the specification, and are used together with the embodiments of the present application to explain the technical solutions of the present disclosure and do not constitute limitations on the technical solutions of the present disclosure.
Fig. 1 shows a structure diagram of a solar power generation component in some embodiments of the present disclosure;
Fig. 2 shows a first structure diagram of a reticular reflective layer in some embodiments of the present disclosure;
Fig. 3 shows a second structure diagram of a reticular reflective layer in some embodiments of the present disclosure;
Fig. 4 shows a third structure diagram of a reticular reflective layer in some embodiments of the present disclosure;
Fig. 5 shows a sectional view along a-a' in FIG.4.

### DETAILED DESCRIPTION

To make the objectives, technical solutions, and advantages of the present disclosure clearer, the embodiments of the present disclosure will be described in detail below with reference to the accompanying drawings. It should be noted that, the embodiments in the present disclosure and the features in the embodiments can be combined with each other arbitrarily, without conflict.

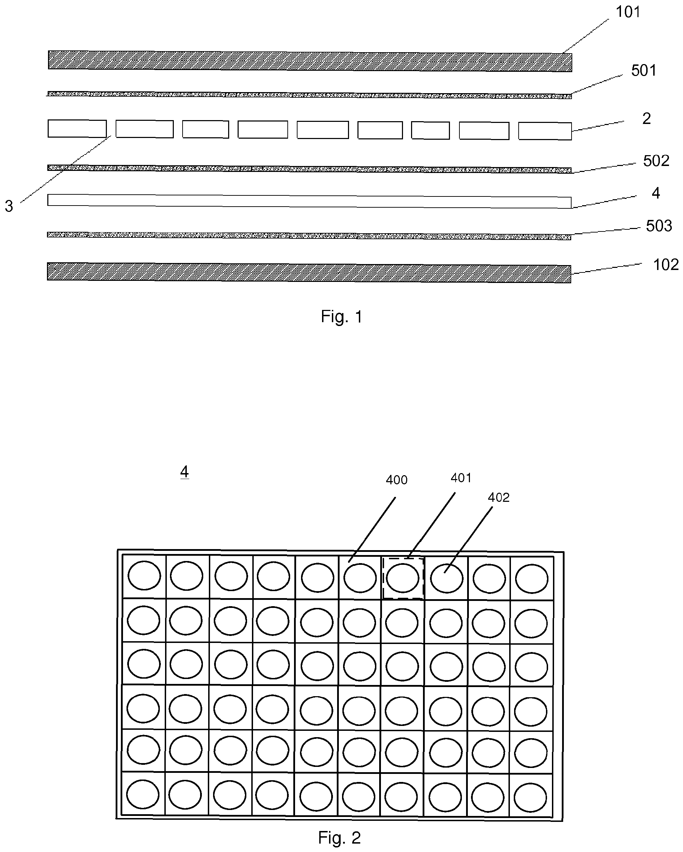

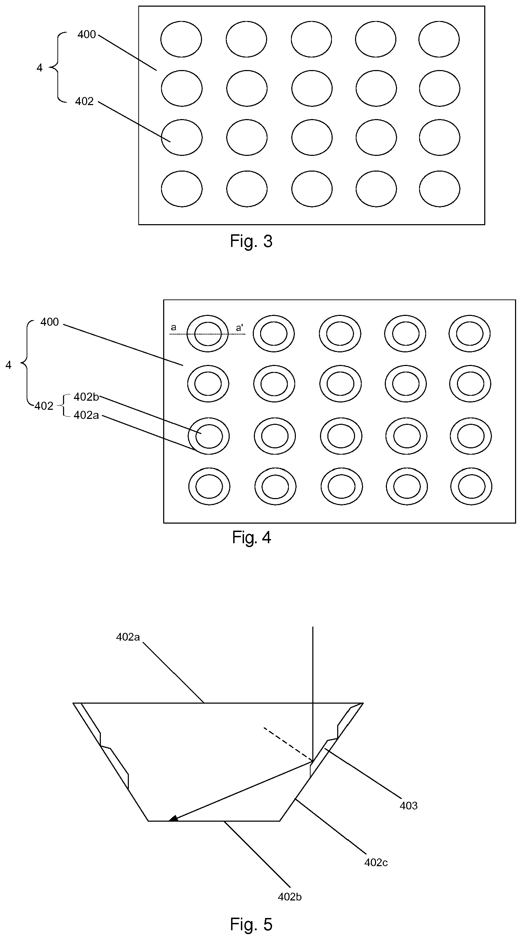

As shown in Fig. 1 and Fig. 3, a solar power generation component provided by some embodiments of the present disclosure includes a first substrate 101, a second substrate 102, a photoelectric transformation element including a plurality of solar cell chips 2, and a reticular reflective layer 4. The first substrate 101, the photoelectric transformation element, the reticular reflective layer 4 and the second substrate 102 are disposed in sequence from top to bottom. The plurality of solar cell chips 2 are disposed on the reticular reflective layer 4, and the adjacent solar cell chips define a gap 3. The reticular reflective layer 4 includes a reticular frame 400 located below the gaps 3 among the plurality of solar cell chips 2.

It can be understood that the plurality of solar cell chips 2 are single-sided solar cell chips or double-sided solar cell chips. The arrangements of the plurality of solar cell chips 2 are various. For example, the plurality of solar cell chips 2 are arranged side by side with intervals, so that the gaps 3 are provided among the plurality of solar cell chips. The plurality of solar cell chips are combined to form a regular shape.

In some embodiments, the plurality of solar cell chips are combined to form a rectangle. The plurality of solar cell chips 2 are connected in series to form a plurality of battery arrays by a conductive material. The conductive material may be a solder ribbon, a conductive tape, or a copper tape, but is not limited thereto.

In a case that the solar power generation component provided by the embodiments of the present disclosure generates electricity, a portion of the light passing through the first substrate 101 from the outside is irradiated onto adjacent surfaces of the plurality of solar cell chips, the adjacent surfaces are surfaces of the plurality of solar cell chips close to the first substrate 101, so that the plurality of solar cell chips output electrical energy. Another portion of the light passing through the first substrate 101 from the outside passes through the gaps 3 provided among the plurality of solar cell chips, so that the another portion of the light irradiates onto an adjacent surface of the reticular frame 400 of the reticular reflective layer 4, the adjacent surface is a surface of the reticular frame 400 which is close to the first substrate. The adjacent surface of the reticular frame 400 of the reticular reflective layer 4, which is close to the first substrate 101, reflects the another portion of the light, so that this portion of the light passes through the gaps 3 and is emitted to the first substrate 101. The first substrate 101 reflects again all or part of this portion of the light, so that the light reflected by the first substrate 101 is emitted toward the plurality of solar cell chips, thereby increasing a utilization rate of the light.

In some embodiments, as shown in Fig. 2, the plurality of solar cell chips included in the above solar cell component are double-sided solar cell chips. And a material of the reticular reflective layer 4 is a double-sided reflective material, that is, the reticular reflective layer 4 is a double-sided reflective layer. Since the reticular frame 400 of the reticular reflective layer 4 is located below the gaps provided among the plurality of solar cell chips, the reticular frame 400 included in the reflective layer 4 substantially does not shield the plurality of solar cell chips 2. At this moment, light passing through the second substrate 102 from the outside is irradiated toward the plurality of solar cell chips 2 without being shielded by the reticular frame 400. Based on this, the reticular frame 400 is mainly arranged below the gaps 3 among the plurality of solar cell chips 2 and in a region where the plurality of solar cell chips 2 do not exist.

In a case that the solar cell component generates electricity, in addition to generating electricity by using light passing through the first substrate 101 from the outside toward surfaces of the plurality of solar cell chips close to the first substrate 101, light passing through the second substrate 102 from the outside to surfaces of the plurality of solar cell chips close to the second substrate 102 may also be used for generating electricity. Moreover, the reticular reflective layer 4 is a double-sided reflective layer, a portion of the light passing through the second substrate 102 from the outside is emitted toward the surfaces of the plurality of solar cell chips close to the second substrate 102, and another portion of the light passing through the second substrate 102 from the outside is emitted toward the surface of the reticular frame 400 close to the second substrate 102. The surface of the reticular frame 400 close to the second substrate 102 reflects the another portion of the light toward the second substrate 102, then the second substrate 102 totally or partially reflects this portion of the light toward the plurality of solar cell chips, as a result, a reflection efficiency of transmitted light on both sides of each of the plurality of solar cell chips is increased.

In addition, in a case that the reticular frame 400 of the reticular reflective layer 4 is located below the gaps 3 provided among the plurality of solar cell chips, the reticular reflective layer 4 does not affect light absorption of the surfaces of the plurality of solar cell chips close to the second substrate 102, while a reflection efficiency of light from the outside transmitted from the gaps 3 provided among the plurality of solar cell chips is effectively increased, thereby reducing a loss of the transmitted light. In this way, the solar power generation component may make full use of the light reflected by the reticular reflective layer 4 to generate electricity. Therefore, a generating efficiency of the solar power generation component is significantly improved, compared with the generating efficiency of a conventional double-sided power generation component.

In some embodiments, as shown in Fig. 2, a thickness of the reticular reflective layer 4 is 0.1 mm ∼ 1 mm. For example, the thickness of the reticular reflective layer 4 is 0.1 mm, 0.6 mm, or 1 mm. In a case that the thickness of the reflective layer 4 is greater than 1 mm, the reticular reflective layer 4 is relatively thick, which is not helpful for the lightening and thinning of the solar power generation component. In a case that the thickness of the reticular reflective layer 4 is less than 0.1 mm, a reflection effect of the light may be affected by the reticular frame 400 included in the reticular reflective layer 4. In a case that the thickness of the reflective layer 4 is 0.1 mm to 1 mm, this thickness can ensure that the reticular reflective layer 4 has a good reflection effect without increasing excessively the thickness of the solar power generation component.

In some embodiments, in a case that the plurality of solar cell chips included in the above solar cell component are double-sided solar cell chips, and then in a case that the reticular reflective layer 4 is a double-sided reticular reflective layer, if the surfaces of the plurality of solar cell chips close to the first substrate 101 serve as the main absorption surfaces, and the surfaces of the plurality of solar cell chips close to the second substrate 102 serve as the auxiliary absorption surfaces, a refractive index of a surface of the reticular reflective layer 4 close to the first substrate 101 is greater than 80%, and a refractive index of a surface of the reticular reflective layer 4 close to the second substrate 102 is greater than 60%. The reticular reflective layer 4 may be TPT (Tedlar/PET/Tedlar), PET (polyethylene terephthalate), aluminum foil or the like. For the refractive index, it is defined as a percentage of total radiant energy reflected by an object to total radiant energy.

As shown in Fig. 3, the above-mentioned reticular reflective layer 4 further includes a plurality of through holes 402 which are arranged as a reticular shape. A cross-sectional area of one of the plurality of through holes 402 is greater than or equal to an area of a corresponding one of the plurality of solar cell chips 2. An orthographic projection of the corresponding one of the plurality of solar cell chips 2 on the second substrate 102 is disposed within an orthographic projection of the one of the plurality of through holes 402 on the second substrate 102, so that the reticular frame 400 of the reticular reflective layer 4 is located directly below the gaps 3 which are provided among the plurality of solar cell chips 2. In this way, the characteristics of the power generation component are ensured, and an absorption rate (or a utilization rate) of the light on the surfaces of the plurality of solar cell chips close to the first substrate 101 or on the surfaces thereof close to the second substrate 102 is increased, and the amount of power generated by the power generation component is increased.

As shown in Fig. 2, the reticular layer 4 has a plurality of grids 401, and each of the plurality of grids 401 is composed by one of the plurality of through holes 402 and corresponding edges of the reticular frame 4 which surround the one of the plurality of through holes 402. One of the plurality of solar cell chips 2 is disposed directly above a corresponding one of the grids 401, so that the reticular frame 400 of the reticular reflective layer 4 is located directly below the gaps 3 provided among the plurality of solar cell chips 2. In this way, it is possible to reduce or even avoid an influence of the reticular reflective layer 4 on the absorption of the sunlight by the surfaces of the plurality of solar cell chips 2 close to the second substrate 102. It is possible in turn for the surfaces of the plurality of solar cell chips 2 close to the second substrate 102 to absorb the sunlight to be the maximum, and then the absorbed sunlight is used to generate electricity. Meanwhile, in a case that the reticular reflective layer 4 is a double-sided reticular reflective layer, using the double-sided reflective property of the reticular frames 400 of the reticular reflective layer 4, a reflection efficiency of the transmitted light on the surfaces of the plurality of solar cell chip 2 close to the first substrate 101 or on the surfaces thereof close to the second substrate 102 is effectively improved, so as to reduce the loss of transmitted light, and the above-described solar power generation component has a significantly higher power generation efficiency than a conventional double-sided power generation component.

Exemplarily, a width of one edge of the reticular frame 400 is less than or equal to a width of a corresponding gap 3 which is provided among the adjacent solar cell chips 2, so as to avoid that the width of each edge of the reticular frame 400 is too large. If one edge of the reticular frame 400 is too large, an orthogonal projection of the reticular frames 400 on the second substrate 102 is more or less overlapped with an orthogonal projection of a corresponding one of the plurality of solar cell chips 2 on the second substrate 102, causing the reticular frames 400 to affect the absorption of the sunlight by the surfaces of the plurality of solar cell chips 2 close to the second substrate 102, thereby reducing the generating efficiency of the plurality of solar cell chips.

In some embodiments, the solar power generation component includes the first substrate 101, a first adhesive layer 501, the plurality of solar cell chips 2, a second adhesive layer 502, the reticular reflective layer 4 and the second substrate 102 arranged in sequence from top to bottom. Here, the first substrate 101 is adhesive with the plurality of solar cell chips 2 by the first adhesive layer 501, and the reticular reflective layer 4 is adhesive with the plurality of solar cell chips 2 by the second adhesive layer 2.

In some embodiments, as shown in Fig. 1, the solar power generation component may include the first substrate 101, the first adhesive layer 501, the plurality of solar cell chips 2, the second adhesive layer 502, the reflective layer 4, a third adhesive layer 503, and the second substrate 102 arranged in sequence from top to bottom. The first substrate 101 or the second substrate 102 is selected from any one of an ultra-clear tempered glass, an anti-reflection coated glass, an anti-reflective patterned glass and a light-transmission polymer backplane, such as a transparent polymer backplane. The first substrate 101 and the second substrate 102 are configured to fix and protect the plurality of solar cell chips 2. The first substrate 101 is adhesive with the plurality of solar cell chips 2 by the first adhesive layer 501. The reticular reflective layer 4 is adhesive with the plurality of solar cell chips 2 by the second adhesive layer 502. The reticular reflective layer 4 is adhesive with the second substrate 102 by the third adhesive layer 503. There is no compatibility problem between the reticular reflective layer 4 and the first adhesive layer 501, the second adhesive layer 502, or the third adhesive layer 503 in the solar power generation component. The first adhesive layer 501, the second adhesive layer 502, or the third adhesive layer 503 is selected from any one of an ethylene-vinyl acetate copolymer (abbreviated as EVA) adhesive layer, an ethylene-ethyl acrylate (abbreviated as EEA) adhesive layer and a polyamide (abbreviated as PA) adhesive layer. The first adhesive layer 501, the second adhesive layer 502, and the third adhesive layer 503 are configured to cohere and fix the above layers of the solar power generation component.

In some embodiments, as shown in Fig. 1, the first adhesive layer 501, the second adhesive layer 502 and the third adhesive layer 503 are configured to be adhesive with the first substrate 101, the plurality of solar cell chips 2, the reticular reflective layer 4 and the second substrate 102 included in the solar power generation component.

In some embodiments, the plurality of solar cell chips 2 included in the above solar power generation component are double-sided solar cell chips. At this time, an orthographic projection of the reticular frame 400 on the second substrate 102 is located within orthographic projections of the gaps 3 on the second substrate 102. It may basically prevent the reticular frame 400 from shelding the light which passes through the second substrate 102 from the outside and is emitted toward the surfaces of the plurality of solar cell chips close to the second substrate 102, thus the absorption rate of the light on the surfaces of the plurality of solar cell chips close to the second substrate 102 is increased.

In some embodiments, each of the plurality of through holes 402 includes a first opening 402a and a second opening 402b oppositely arranged. The first opening 402a is adjacent to the gaps 3. The second opening 402b is adjacent to the second substrate 102. An orthogonal projection of the first opening 402a on the second substrate102 is greater than an orthogonal projection of the second opening 402b on the second substrate 102. Therefore, each of the through holes 402 has a trumpet structure.

Exemplarily, an orthogonal projection of one of the plurality of solar cell chips 2 on the second substrate 102 is located within an orthogonal projection of the second opening 402b of a corresponding one of the plurality of through holes 402 on the second substrate 102. In this way, every position on the surfaces of the plurality of solar cell chips close to the first substrate 101 may receive the sunlight which passes through the first substrate 101 from the outside.

The inner wall of each of the plurality of through holes 402 is the side surface of the reticular frame 400. In this way, when the light passing through the first substrate 101 from the outside is emitted toward the reticular reflective layer 4, the light may be emitted not only toward the surface of the reticular frame 400 close to the first substrate 101 but also toward the side surface of the reticular frame 400. In a case that one of the plurality of through holes 402 has a trumpet structure, the side surface of the reticular reflective layer 4 has an approximately beveled shape. Therefore, the side surface of the reticular frame 400 may not only reflect the light passing through the first substrate 101 from the outside, but also enable the reflected light to better enter the surfaces of the plurality of solar cell chips close to the first substrate 101.

Exemplarily, an inclination degree of the side surface of the reticular frame 400 determines an exit angle of the light reflected from the side surface of the reticular frame 400. The greater the inclination degree of the side surface is, the easier the light reflected by the side surface is to be incident onto the surfaces of the plurality of solar cell chips close to the first substrate 101.

In some embodiments, in a case that one of the plurality of through holes 402 has a trumpet structure, especially the one of the plurality of through holes 402 may have a pyramidal structure or a round table structure. Here, a cross-section of the one of the plurality of through holes 402 in a plane perpendicular to the first substrate 101 is trapezoidal.

In some embodiments, as shown in Fig. 5, the inner wall of each of the plurality of through holes 402 is provided with a directional reflection structure 403. The directional reflection structure 403 is configured to adjust the reflection angle of the light emitted toward the inner wall of each of the plurality of through holes 402, so as to enable the light emitted toward the inner wall to be better utilized by at least one of the plurality of solar cell chips.

Exemplarily, the above-mentioned directional reflection structure 403 is a round-corner reflective structure, a chamfered reflective structure or a deformed reflective structure, but is not limited thereto.

In some embodiments, as shown in Fig. 1, the above reticular reflective layer 4 is a double-sided reflective layer. The plurality of solar cell chips are double-sided solar cell chips. A refractive index of the first adhesive layer 501 is greater than a refractive index of the first substrate 101. A refractive index of the first substrate 101 is greater than a refractive index of air. After the light passing through the first substrate 101 from the outside is transmitted to the reticular frame 400 included in the reticular reflective layer 4, the light reflected by the reticular frame 400 passes through one of the corresponding gaps 3 and is emitted toward the first adhesive layer 501. Here, the refractive index of the first adhesive layer 501, the refractive index of the first substrate 101 and the refractive index of air are matched to each other, so that the light reflected by the reticular frame 400 may be mostly or even completely reflected by the first substrate 101 toward the surfaces of the plurality of solar cell chips close to the first substrate 101.

Similarly, as shown in Fig. 1, the refractive index of the third adhesive layer 503 is greater than the refractive index of the second substrate 102. The refractive index of the second substrate 102 is greater than the refractive index of the air. After the light passing through the second substrate 102 from the outside is transmitted to the reticular frame 400 included in the reticular reflective layer 4, the light reflected by the reticular frame 400 passes through one of the corresponding gaps 3 and is emitted toward the third adhesive layer 503. Here, the refractive index of the third adhesive layer 503, the refractive index of the second substrate 102 and the refractive index of the air are matched to each other, so that the light reflected by the reticular frame 400 may be mostly or even completely reflected by the second substrate 102 toward the surfaces of the plurality of solar cell chips close to the second substrate 102.

In some embodiments, the plurality of solar cell chips included in the solar power generation component are double-sided solar cell chips. The surfaces of the plurality of solar cell chips close to the first substrate 101 serve as surfaces which mainly absorb the sunlight, and the surfaces of the plurality of solar cell chips close to the second substrate102 serve as surfaces which auxiliarily absorb the sunlight. In this case, a refractive index of a surface of the reticular reflective layer 4 close to the first substrate 101 is greater than 80%, and a refractive index of a surface of the reticular reflective layer 4 close to the second substrate 102 is greater than 60%. In this way, it may ensure that the surface of the reticular reflective layer 4 close to the first substrate 101 may reflect more light to the first substrate 101, so that the first substrate 101 reflects the light to the surfaces of the plurality of solar cell chips close to the first substrate 101, thereby improving the power generation efficiency of the solar power generation component.

Although the disclosed embodiments of the present disclosure are described as above, the contents described are merely embodiments for the purpose of understanding of the present disclosure, and are not intended to limit the disclosure. Any modification and variation in the form and details of the implementation may be made by those skilled in the art, without departing from the spirit and scope disclosed by the present disclosure. However, the scope of patent protection of the present disclosure shall still based on the scope defined by the appended claims.

It can be understood that the above embodiments are merely illustrative embodiments for the purpose of illustrating the principles of the disclosure, but the disclosure is not limited thereto. It will be apparent to those skilled in the art that various changes and modifications can be made therein without departing from the spirit and essence of the disclosure, which are also considered to be within the scope of the disclosure.

## Claims

1. A solar power generation component, comprising a first substrate, a photoelectric transformation element, a reticular reflective layer, and a second substrate arranged in sequence from top to bottom, the photoelectric transformation element includes a plurality of solar cell chips, wherein,
the adjacent solar cell chips define a gap, the reticular reflective layer includes a reticular frame located below the gaps among the plurality of solar cell chips.

2. The solar power generation component according to claim 1, further comprising a first adhesive layer and a second adhesive layer; wherein,
the first substrate is adhesive with the plurality of solar cell chips by the first adhesive layer, and the reticular reflective layer is adhesive with the plurality of solar cell chips by the second adhesive layer.

3. The solar power generation component according to claim 1, wherein the reticular reflective layer further comprises a plurality of through holes which are arranged as a reticular shape, wherein,
a cross-sectional area of one of the plurality of through holes is greater than or equal to an area of a corresponding one of the plurality of solar cell chips, and an orthographic projection of the corresponding one of the plurality of solar cell chips on the second substrate is disposed within an orthographic projection of the one of the plurality of through holes on the second substrate, so that the reticular frame of the reticular reflective layer is located directly below the gaps which are provided among the plurality of solar cell chips.

4. The solar power generation component according to claim 3, wherein the reticular reflective layer further comprises a plurality of grids each of which is composed by one of the plurality of through holes and corresponding edges of the reticular frame which surround the one of the plurality of through holes, one of the plurality of solar cell chips is disposed directly above a corresponding one of the plurality of grids.

5. The solar power generation component according to claim 4, wherein a width of one edge of the reticular frame is less than or equal to a width of a corresponding gap which is provided among the adjacent solar cell chips.

6. The solar power generation component according to claim 2, further comprising a third adhesive layer, wherein,
the reticular reflective layer is adhesive with the second substrate by the third adhesive layer.

7. The solar power generation component according to claim 6, wherein, the first adhesive layer, the second adhesive layer or the third adhesive layer is selected from any one of an ethylene-vinyl acetate copolymer adhesive layer, an ethylene-ethyl acrylate adhesive layer and a polyamide adhesive layer.

8. The solar power generation component according to any one of claims 1-7, wherein, the first substrate or the second substrate is selected from any one of an ultra-clear tempered glass, an anti-reflection coated glass, an anti-reflective patterned glass and a light-transmission polymer backplane.

9. The solar power generation component according to any one of claims 1-7, wherein the plurality of solar cell chips are double-sided solar cell chips.

10. The solar power generation component according to any one of claims 1-7, wherein a material of the reticular reflective layer is a double-sided reflective material.

11. The solar power generation component according to any one of claims 1-7, wherein a thickness of the reticular reflective layer is 0.1 mm∼1 mm.

12. The solar power generation component according to claim 1, wherein an orthogonal projection of the reticular frame on the second substrate is located within orthographic projections of the gaps on the second substrate.

13. The solar power generation component according to claim 3, wherein each of the plurality of through holes comprises a first opening and a second opening oppositely arranged;
the first opening is adjacent to the gaps, and the second opening is adjacent to the second substrate; an orthogonal projection of the first opening on the second substrate is greater than an orthogonal projection of the second opening on the second substrate; and
the orthographic projection of the corresponding one of the plurality of solar cell chips on the second substrate is disposed within the orthographic projection of the second opening of the one of the plurality of through holes on the second substrate.

14. The solar power generation component according to claim 13, wherein a cross-section of at least one of the plurality of through holes in a plane perpendicular to the second substrate is trapezoidal.

15. The solar power generation component according to claim 13, wherein an inner wall of each of the plurality of through holes is provided with a directional reflection structure, and the directional reflection structure is configured to adjust a reflection angle of light emitted toward the inner wall of each of the plurality of through holes.

16. The solar power generation component according to claim 12 or 13, further comprising a first adhesive layer and a third adhesive layer; wherein,
the first substrate is adhesive with the plurality of solar cell chips by the first adhesive layer, and the reticular reflective layer is adhesive with the second substrate by the third adhesive layer, wherein the reticular reflective layer is a double-sided reflective layer, and the plurality of solar cell chips are double-sided solar cell chips; and
a refractive index of the first adhesive layer is greater than that of the first substrate, and a refractive index of the first substrate is greater than that of the air;
a refractive index of the third adhesive layer is greater than that of the second substrate, and a refractive index of the second substrate is greater than that of the air.

17. The solar power generation component according to claim 1, wherein a surface of the reticular reflective layer close to the first substrate has a refractive index greater than 80%, and another surface of the reticular reflective layer close to the second substrate has a refractive index greater than 60%.
